# EUROPEAN PATENT APPLICATION

(11) **EP 1 894 906 A1**
(43) Date of publication of application: **05.03.2008**
(21) Application number: 06017856.3
(22) Date of filing: 28.08.2006
(51) Int. Cl.: C04B 35/58, H01L 39/24

(54) **Superconducting element containing MgB2**

(71) Applicant: Bruker BioSpin AG, 8117 Fällanden (CH)
(72) Inventor: Flükiger, René, 1228 Plan-Lex-Onates (CH); Lezza, Paola, 1227 Les Acacias, Genève (CH)
(74) Representative: Kohler Schmid Möbus

(57) **Abstract**

A superconductive element containing Magnesiumdiboride (=MgB₂), comprising at least one superconductive filament (1) of a size between 5 and 500 micron, which is enclosed in a metallic matrix (2) and also comprising at least one highly conductive ohmic element (4),the superconducting filaments being separated from the matrix (2) and from the conductive ohmic element (4) by a protective metallic layer (3),
the superconductive filament being formed by a reaction between Boron (B) and Magnesium (Mg) powders and Boron carbide (=B₄C) powders as a first additive is characterized in that one or more additional powder additives containing Carbon are present in the reaction of the powder mixtures including Mg, B and B₄C. The reaction of the powder mixture to MgB₂ is carried out at temperatures between 500 and 760°C leading to a maximum of the critical current density, J_{c}, at temperatures at 760°C and below.

## Description

The invention relates to a method for producing a superconductive element, in particular a monofilament or a multifilament wire with filaments 1 of a size between 10 and 1'000 microns, which are enclosed in a metallic matrix 2 and also comprise a highly conductive element 4, the superconducting element being separated from the matrix 2 and from the conductive element 4 by a protective metallic layer 3.

The deformation of a monofilamentary or a multifilamentary wire occurs following standard swaging, drawing or rolling processes.

The superconductive filament is formed at the end of the deformation to a wire by a reaction between powders mixtures consisting of various powders of particle size between 5 nm and 5 microns, the main components being Boron (B) and Magnesium (Mg).

In contrast to the common use of only one powder additive, the invention introduces a new strategy of multiple powder additives to Mg and B, the interaction between the various additive powder types leading to new conditions, which may have a positive influence on the critical current density of the wire.

B₄C is chosen as a first additive powder, in addition to one or more other powder additives, all containing Carbon.

The choice of the second or a third additive is characterized in that a maximum of the critical current density, J_{c}, is obtained by a reaction equal to or inferior to 760°C. The reaction can occur in one or more steps, at temperatures between 500 and 760°C. Each one of the additives individually contributes in enhancing the amount of dissolved Carbon in the MgB2 structure as detected by X ray diffraction,

At least one of the Carbon containing additives other than B₄C is a binary, ternary or quaternary compound, which can be chosen among the compounds SiC, Mo₂C, WC, VC, TaC, TiC, ZrC, NbC. The ratio between B₄C and the sum of additional additives to B₄C varies between the ratios 15:1 and 1:15,

At least one of the additives other than B₄C is Carbon in the elementary form, comprising nanotubes or diamond, or a carbonate or a carbohydrate, or one of the compounds (R.E.)C₂ or (La₁-ₓMₓ)C₃, with x = Lu, Sc, Th, Y, or graphite intercalated compounds.

The B₄C powders as well as the other additive powders have a particle size comprised between 5 nm and 5 microns, the B₄C powders and the other additive powders being introduced simultaneously in the original powder mixture, the content of B₄C and of each one of these additives is comprised between 0.1 and 15 wt.% with respect to MgB₂, the sum of all additives, including B₄C is comprised between 1 and 20 wt.% with respect to MgB₂, the ratio Mg:B between the initial Magnesium and Boron powders can be varied between 1 : 2 and 0.8 : 2.2.

A particular point of the invention is that the additional powders to B₄C can be chosen among Carbon-free material powders, among Magnesium based compounds (Mg₂Ce, Mg₂Cu, Mg₂Ga and Mg₂Si), or borides (MgB₄, Mo₂B₅, Mo₃B₄, MoB, WB₂, W₂B₅, HfB, ZrB₂, TaB₂, Ta₃B₄, TiB₂, NbB₂, VB₂, UB₂, RuB₂, CrB₂, BaB₆, (R.E.)B₆, (R.E.)B₁₂ (where R.E. is a rare earth element), or silicides (MoSi₂, Mo₃Si, WSi₂), or nitrides (Si₃N₄, BN, AIN), as well as oxides of the type (RE)₂O₃ (where RE = La, Ce, Pr, Nd, Sm, Eu, Gd, Tb, Dy, Ho, Er, Tm, Yb, Lu) or Al₂O₃, V₂O₅, Nb₂O₅, Ta₂O₅, SiO₂ HfO, ZrO, MgO, ZrMo₂O₈, ZrW₂O₈, Y₂(WO₄)₃, Al₂TiO₅, Ti₂BaMgO₄, SnO₂, NbO₂, BaCO₃ and finally, also single metallic elements (Nb, Ta, V, Mo, W, Ti, Zr and Hf).

The compound MgB₂ is known to exhibit a superconducting transition at T_{c} = 39 K. There is a large amount of articles describing the fabrication of superconducting wires and tapes based on this compound, inside a metallic matrix consisting either of Fe, Ni, Nb, Ti, Monel or stainless steel. Since these matrix materials have a too high electrical resistivity, the thermal stabilization of the wire configuration also includes a certain amount of highly conductive Cu. The Cu stabilizer is separated from the superconducting filament by a protective layer, which consists of Nb, Ta, Ti or of the industrial alloy NbTi.

Monofilamentary and multifilamentary wires based on MgB₂ have been fabricated in a large number of laboratories and are today already available in km lengths.

The scope of the invention is to increase the values of the critical current density, which is mandatory for a wide application of these conductors.

With the progress of the superconducting current carrying capability of MgB₂ wires since its discovery in 2001 the question arises whether this compound can in some particular cases be considered as a possible substitute for NbTi or Nb₃Sn. The positive arguments for MgB₂ are
* its high transition temperature,
* its weak-link free character
* the low material cost
* small anisotropy.

MgB₂ appears is a promising candidate for engineering applications, as MRI magnets at temperatures around 20 K and intermediate field inserts for NMR magnets at 2 K.

However, further improvements of the superconducting parameters are required, in particular the values of B_{c2} (the upper critical field), Bᵢₙ (the irreversibility field, above which no supercurrent can be carried) and J_{c} (the critical current density).

As a general rule, the developments have to be carried out in order to obtain the highest possible J_{c} values, measured at the conditions of temperature and field corresponding to the individual application,

The present invention is centered on the fabrication of MgB₂ wires and tapes by the *in situ* method. For a monofilamentary wire, this method consists in mixing Magnesium and the Boron powders, filling them into a metallic can (Fe, Ni or Ni alloys, Ti or Ti alloys, stainless steel) and to deform them to a wire (of diameters between 0.6 and 1.2 mm) or a tape (typical sizes: 4 x 0.3 mm²). In the case of industrial multifilamentary wires or tapes, the process comprises one intermediate bundling step, followed by deformation to the same final size between 0.6 an 1.2 mm. In order to fulfil the criteria for thermal stabilization, the metallic can also comprises one or more elongated elements of highly conducting Cu.

The phase MgB₂ can be formed by a reaction at temperatures ranging from 500 to 760°C, during times ranging from 2 minutes to several hours. In order to prevent an interaction between the powder mixture and the metallic can during reaction, these elements are separated by a protecting barrier, which can consist of Nb, Ta or Ti.

In order to reduce the MgB₂ grain size, which is a condition for enhanced critical current density, the reaction in an industrial MgB₂ wire with additives should occur as temperatures as low as possible, always below 760°C. This temperature is lower than the reported reaction temperature for optimized MgB₂ wires containing B₄C. A reaction temperature of 850°C for B₄C additives was used by A. Yamamoto, J.-I. Shimoyama, S. Ueda, 1. lwayama, S. Horii, K. Kishio, in Superconducting Science and Technology, 18(2005)1323.
1. A temperature of 800°C for wires with B₄C additives .is reported by P. Lezza, C. Senatore and R. Flükiger, in cond-mat. 0607073, June 2006 (arXiv.org > cond-mat > cond-mat.supr-con), these authors mention a reaction at 720°C, which was too low for obtaining optimized J_{c} values. There is no indication in the literature about optimized reactions of Bom, Magnesium and B₄C below 800°C.

The present invention describes for the first time the use of at least two additives, with at least one of them Containing Carbon. The new strategy consists in creating new sources of improvement by the combination of various additives to MgB₂, thus inducing enhanced properties to those obtainable by the single additives.

One of the benefits of additional additives is to promote the reaction between the various additives, leading to a decomposition and thus to the lowering of the reaction temperature. This holds as well for Carbon containing additives as for Carbon-free additives. This effect is even reinforced if the decomposition temperature of the additional additive or of the additional additives is lower than the optimized reaction temperature with the B₄C additive.

A second benefit of additional additives is to increase the amount of Carbon in the MgB₂ phase to values exceeding those of each one of the additives added separately.

The benefit of the substitution of Carbon or of any other element in the MgB₂ lattice is to enhance the electrical resistivity and thus the critical current density at a given magnetic field. Indeed, the phase MgB₂ forms in a highly ordered state ("clean" limit), with very low values of the normal state electrical resistivity just above T_{c}, ρₒ. The substitution, caused by the presence of additives, enhances the value of ρₒ, which leads to an enhancement of the critical field. This follows from the article of Dou et al., who first reported an enhancement of J_{c} after adding nanometric SiC powders to MgB₂: S.X. Dou, S. Soltanian. S. Horvat, X.L: Wang, S. H. Zhou, M. lonescu, H.K. Liu, P. Munroe, M. Tomsic, Applied Physics Letters, 81(2002)3419.

This is also demonstrated by the work of Ribeiro, who added nanometric Carbon to MgB₂: R.A. Ribeiro, S.L. Bud'ko, C. Petrovic, P.C. Canfield, in Physica C 384(2003)227.

A third benefit of additional additives is to combine different mechanisms, hoping to add their effects to a supplementary enhancement of J_{c}. The possible mechanisms in addition to the substitution of Carbon are:
* the substitution of Magnesium,
* a higher densification of the powder during reaction,
* the formation of less secondary phases,
* the enhanced formation of dislocations at the grain boundaries or
* the reduction of the MgB₂ grain sizes and domains.

An improvement of the transport critical current density, *J_{c},* of MgB₂ wi res was obtained by P.Lezza et al. (P. Lezza, C. Senatore and R. Flükiger, in cond. mat. 0607073, June 2006) after addition of 10 wt.% B₄C powders, after reaction at 800°C: *J_{c}* values of 1'104 A/cm² at 4.2 K and 9T were obtained for wires of 1.11 mm diameter in a Fe matrix. The starting mixture of Mg and B was doped with sub-micrometric B₄C, the ratio being Mg : B : B₄C = 1:2: 0.08, corresponding to 10 wt.% B₄C. For T > 800°C, a decrease of *J_{c}* was found, due to the reaction with the Fe sheath. In order to investigate the origin of the improvement of the transport properties for heat treatments up to 800°C, X-ray diffraction measurements were performed. A comparison with the literature data shows that the addition of B₄C powders leads to the second highest improvement of *J_{c}* reported so far after SiC, thus constituting an alternative for future applications.

The present invention constitutes an unexpected step further after our recent work (P. Lezza, C. Senatore and R. Flükiger, in cond. mat. 0607073, June 2006), where the addition of 10 wt.% B₄C to MgB₂ wires caused an enhancement of J_{c} up to 1 x 10⁴ A/cm² at 9-6 T and 4.2 K. By the addition of a second additive, SiC, with the compositions 7.5 wt.% B₄C + 2.5 wt.% SiC, we have now obtained the same value at 11.2 T, i.e. 1.6 T higher. Further enhancements are expected.

After reaction, the nature of the initial additives can be identified by an elemental analysis, by the value of the lattice parameter and by the additional phases present in the superconducting filaments.

Especially in the scope of the present invention is a superconducting element produced by a process as mentioned above, characterized in that the parts constituting the superconducting element (a wire or a tape) are in accordance to the features of the enclosed drawings. The embodiments mentioned are not to be understood as exhaustive enumeration but rather have exemplary character for the description of the invention.

### Drawings

The invention is shown in the drawings.

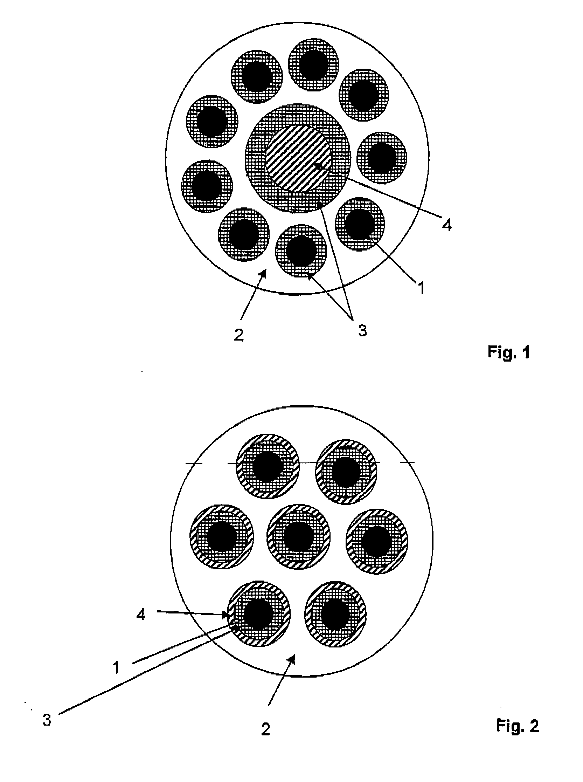

- Fig. 1: shows a cross section of a superconducting multifilamentary wire based on MgB₂, characterized in that the Cu stabilizer 4 is located at the centre, protected from the matrix 2 by a barrier 3. The filaments **1** are distributed throughout the cross section, and are separated from the matrix **2** by a barrier **3**.
- Fig. 2: shows a cross section of a superconducting multifilamentary wire based on MgB₂, characterized in that a barrier **3** separates each filament 1 from the Cu stabilizer **4**. The filaments 1, surrounded by the barrier 3 and the Cu stabilizer 4 are distributed throughout the cross section.

## Claims

1. Superconductive element containing Magnesiumdiboride (=MgB₂), comprising
at least one superconductive filament (1) of a size between 5 and 500 micron, which is enclosed in a metallic matrix (2) and also comprising at least one highly conductive ohmic element (4),
the superconducting filaments being separated from the matrix (2) and from the conductive ohmic element (4) by a protective metallic layer (3), the superconductive filament being formed by a reaction between Boron (B) and Magnesium (Mg) powders and Boron carbide (=B₄C) powders as a first additive
**characterized in that**
one or more additional powder additives containing Carbon are present in the reaction of the powder mixtures including Mg, B and B₄C

2. Superconductive element according to claim 1 **characterized in that** the respective amounts of B₄C and the sum of additional additives to B₄C vary between the ratios 15:1 and 1:15.

3. Superconductive element according to anyone of the preceding claims, **characterized in that** at least one of the additional additives is a binary, ternary or quaternary compound, based in particular on SiC, Mo₂C, WC, VC, TaC, TiC, ZrC, NbC.

4. Superconductive element according to anyone of the preceding claims, **characterized in that** at least one of the additional additives is Carbon in the elementary form, in particular nanotubes or diamond.

5. Superconductive element according to anyone of the preceding claims, **characterized in that** at least one of the additional additives is carbonate or a carbohydrate.

6. Superconductive element according to anyone of the preceding claims, **characterized in that** at least one of the additional additives is one of the compounds (R.E.)C₂ or (La₁₋ₓMₓ)C₃, with x = Lu, Sc, Th, Y, or graphite intercalated compounds.

7. Superconductive element according to anyone of the preceding claims, **characterized in that** the B₄C powders as well as the additional additive powders consist of particles of a size between 5 nm and 5µm.

8. Superconductive element according to anyone of the preceding claims, **characterized in that** the content of B₄C powder and of each one of the additional additives is between 0.1 and 15 wt.% with respect to the MgB₂ content.

9. Superconductive element according to anyone of the preceding claims, **characterized in that** the sum of all additives, including B₄C is between 1 and 20 wt. % with respect to the MgB₂ content.

10. Superconductive element according to anyone of the preceding claims, **characterized in that** the ratio Mg:B between the contents of the initial Magnesium and Boron powders is between 1 : 2 and 0.8 : 2.2.

11. Superconductive element according to anyone of the preceding claims, **characterized in that** at least one Carbon-free additive is present in the reaction of the powder mixtures including Mg, B and B₄C.

12. Superconductive element according to claim 11, **characterized in that** the Carbon-free additive comprises a binary, ternary or quaternary Mg based compound based on Mg₂Ce, Mg₂Cu, Mg₂Ga and Mg₂Si.

13. Superconductive element according to claim 11 or 12, **characterized in that** the Carbon-free additive comprises a binary, ternary or quaternary compound based on MgB₄, Mo₂B₅, Mo₃B₄, MoB, WB₂, W₂B₅, HfB, ZrB₂, TaB₂, Ta₃B₄, TiB₂, NbB₂, VB₂, UB₂, RuB₂, CrB₂, BaB₆, (R.E.)B₆, (R.E.)B₁₂, where R.E. is a rare earth element.

14. Superconductive element according to claim 11 to 13, **characterized in that** the Carbon-free additive comprises a binary, ternary or quaternary compound based on MoSi₂, Mo₃Si, WSi₂.

15. Superconductive element according to claim 11 to 14, **characterized in that** the Carbon-free additive comprises a binary, ternary or quaternary compounds based on Si₃N₄, BN, Zn(CN)₂, AIN.

16. Superconductive element according to claim 11 to 15, **characterized in that** the Carbon-free additive comprises a binary, ternary or quaternary compound based on (RE)₂O₃, where RE = La, Ce, Pr, Nd, Sm, Eu, Gd, Tb, Dy, Ho, Er, Tm, Yb, Lu, or one of the oxides Al₂O₃, V₂O₅, Nb₂O₅, Ta₂O₅, SiO₂ HfO, ZrO, MgO, ZrMo₂O₈, ZrW₂O₈, Y₂(WO₄)₃, Al₂TiO₅, Ti₂BaMgO₄, SnO₂, NbO₂, BaCO₃.

17. Superconductive element according to claim 11 to 16, **characterized in that** the Carbon-free additive comprises a single metallic elements Nb, Ta, V, Mo, W, Ti, Zr and Hf are present in the reaction of the powder mixtures including Mg, B and B₄C.

18. Superconductive element according to anyone of the preceding claims, **characterized in that** the matrix (2) comprises Fe and/or Fe alloys, Ni and/or Ni alloys, Cu and/or Cu alloys, Ti and/or Ti alloys, stainless steel or combinations thereof.

19. Superconductive element according to anyone of the preceding claims, **characterized in that** the protective metallic layer (3) comprises Nb and/or Nb alloys, Ta and/or Ta alloys, Ti and/or Ti alloys, in particular NbTi.

20. Method for producing a superconductive element according to anyone of the preceding claims, **characterized in that** the reaction of the powder mixture to MgB₂ is carried out at temperatures between 500 and 760°C.

21. Method for producing a superconductive element according to anyone of the preceding claims, **characterized in that** the B₄C powders and the additional additive powders are introduced simultaneously in the original powder mixture.
